# EUROPEAN PATENT SPECIFICATION

(11) **EP 0 412 392 B1**
(45) Date of publication and mention of the grant of the patent: **29.12.1993**
(21) Application number: 90114596.1
(22) Date of filing: 30.07.1990
(51) Int. Cl.: H03G 3/20

(54) **Amplifier for radio transmitter having controllable output power**
Verstärker für Radiosender mit Regelung der Senderausgangsleistung
Amplificateur pour émetteur radio avec puissance de sortie commandée

(30) Priority: 11.08.1989 GB 8918365
(43) Date of publication of application: 13.02.1991
(73) Proprietor: MOTOROLA LTD, Basingstoke, Hampshire RG22 4PD (GB)
(72) Inventor: Bishop, Peter William Dale, Westlea, Swindon, Wiltshire (GB); Grant, Neil, Eltham, London SE9 1HJ (GB)
(74) Representative: Dunlop, Hugh Christopher

(56) References cited:
- EP-A- 0 369 135
- WO-A-86/07216
- DE-A- 3 527 554

## Description

This invention relates to a power amplifier for a radio transmitter having accurately controllable output power suitable for use in cellular radio base stations, particularly for the Pan-European GSM network.

The GSM specification requires that a base station's transmitter has a predetermined maximum output power having a tolerance of -0 or +3dB and may be reduced from its maximum level in up to 21 steps of 2dB with an accuracy of + or - 0.5dB.

The specification is a very demanding one, because, whereas control of output power to a tolerance of + or - 0.5dB at a particular power level and frequency is possible, achievement of this tolerance at any level over a range of 42dB and over a range of frequencies is a requirement not heretofore seen. The set requirement is even more difficult to achieve when the transmitter is hopping from one frequency to another and from one power level to another between time slots, where each time slot lasts for only 577 microseconds.

It is an object of the present invention to provide a transmitter which meets the required specification and is simple, cheap and reliable.

### Summary of the Prior Art

EP-A-0369135 of Motorola Inc., comprised within the state of the art according to Article 54(3) EPC, describes a power amplifier for a radio frequency signal utilizing a microprocessor to address a read-only memory (ROM) to look up a power control value for setting the output power of an RF power amplifier. That amplifier is particularly suitable for meeting the less stringent requirements of the specification for mobile cellular radio transmitters. The output power is measured by means of a detector diode. It is a problem that output power detectors cannot readily measure output power accurately over a power range as great as 42dB. To the contrary, production tolerance and batch tolerance in detector diodes can give rise to a variance of 3-4dB at the extremes of the power range.

### Summary of the Invention

According to the present invention, there is provided an amplifier comprising a controllable output power stage, power setting means for setting the output power, and a control loop for adjusting the output power, the control loop comprising measuring means for measuring the output power and comparison means for comparing the power measured with the power set and adjusting the output power in response thereto, the amplifier further comprising attenuator means switchable into the control loop for causing the measuring means to measure attenuated power, storage means for storing a value for measured power and means for using a stored value derived from a first switched state of attenuation for adjustment of the output power during a second switched state of attenuation, thereby to allow a wide adjustment of output power over a narrow range of measured power.

By this means, only a single setting of the output power needs to be made in the factory, or by a service engineer, and using this reference power, a highly accurate but cheap attenuator, such as a laser etched resistor pad, can be used to provide calibration for other power levels.

The transmitter can perform an automatic calibration routine, which results in a number of reference values stored in memory, each controlling an output power level to a high degree of accuracy.

There is preferably provided a large attenuator and a small attenuator and switching means for switching one or both of said attenuators into the control loop. By this means, the entire power range can be divided up into smaller steps, equivalent to the power attenuation provided by the small attenuator, while the large attenuator can provide power control equal to a number of smaller steps, thus reducing the total number of steps required to span the entire power range.

According to the invention there is also provided a method of controlling the output power of an amplifier, comprising the steps of:
a) setting an output power stage to provide a desired higher output power, attenuating the output power in an attenuator, and measuring and storing a value for the attenuated output power
b) deactivating the attenuator and
c) adjusting the setting of the output power stage until substantially the same output power value is measured as the stored value, thereby providing a decreased output power, the value of which is controllable to substantially the same degree of accuracy as the measurement of the previously attenuated higher output power.

In this manner a higher power level is set in the factory, by a service engineer, or by other means, and, using this higher power level as a reference point, further (lower) power levels are calibrated by the transmitter itself in a two-stage process of power measurement with attenuation and power measurement without attenuation.

A reverse procedure may be used in which a lower power level is set initially and a two-stage calibration is performed by measurement without attenuation and measurement at a higher power with attenuation.

It is preferred that both methods are used and the calibration results are averaged.

A further stage of calibration may be used, in which output power is set to different levels extending over a range by a series of steps including at least one large incremental step in one direction and a series of small incremental steps in the other direction. If the final power level is found to be different to the original level (e.g. due to non-linearity in the amplifier), interpolation may be used to adjust the stored values for the intermediate small incremental steps, so as to equalise the final level to the originally measured level.

### Brief Description of the Drawings

Figure 1 illustrates two methods of power control in accordance with the invention;
Figure 2 shows a block diagram of a power amplifier in accordance with a preferred embodiment of the invention;
Figure 3 shows a graph of detector value versus control voltage for the amplifier of Figure 2; and
Figure 4 shows preferred details of the attenuators and detector of figure 2:
Figure 5 shows preferred details of the portion of figure 4 in dotted outline; and
Figure 6 shows an alternative arrangement for the detector of Figure 2.

### Detailed Description of a Preferred Embodiment

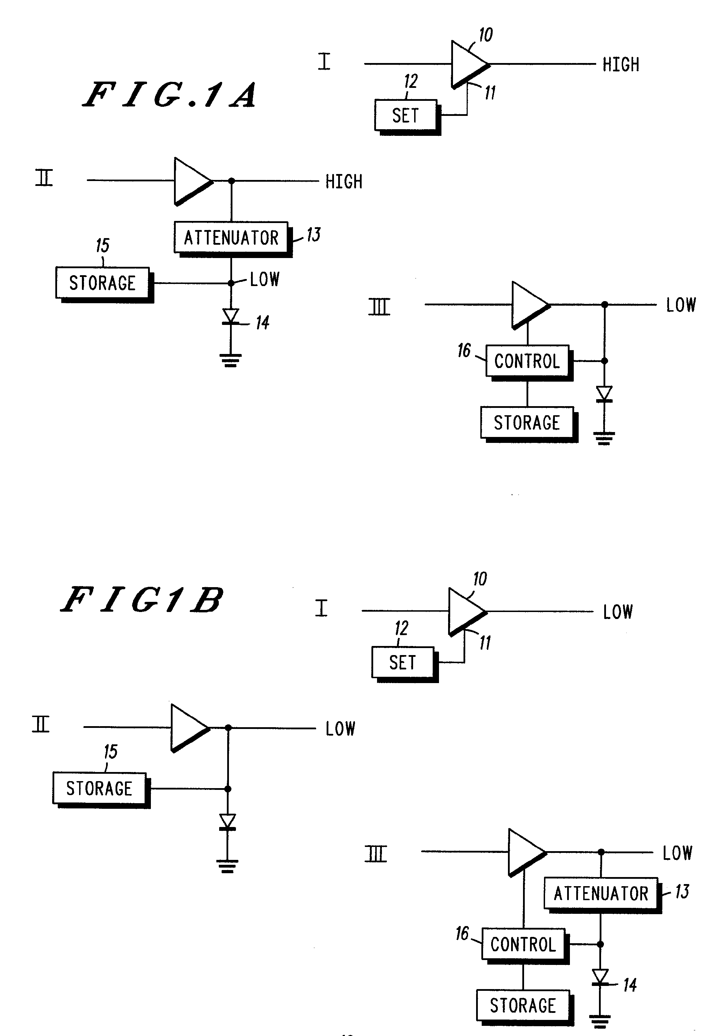

Referring to Figure 1, there are shown two methods of power control in accordance with the invention, illustrated in Figures 1a and 1b respectively.

In Figure 1a, there is shown a power amplifier 10 having a gain input 11 and means 12 for setting the gain input. There is also shown an attenuator 13, a detector 14, storage means 15 and control means 16.

The figure has three parts, representing the steps in the method. The first and second parts in fact represent steps performed simultaneously, while the third part represents a subsequent step.

The operation of the amplifier is as follows. A value is provided by setting means 12, which provides a control voltage on the input 11 of the power amplifier 10, which results in a high power output at the output of the amplifier. The value is pre-calibrated, so that the high output power is accurate to within the desired specification. The output power may be, for example, 80 watts.

As shown in step II, the output power is attenuated in the attenuator 13 to a low power level. The attenuator may provide, for example, 20dB attenuation. The low power level resulting is measured by detector 14, and the value is stored in storage means 15 in order to record the measured power level. In step III, this stored value is recalled and the control means 16 ramps up the control voltage to the power amplifier from zero volts until the output power level measured by the detector 14 without any attenuation is equal to the value stored in step II.

In an alternative method, illustrated in Figure 1b, which may be considered the opposite to the above method, the initial power level set by setting means 12 is a low power level, and the measured value is stored in storage means 15. The attenuator 13 is then switched into the circuit between the output of the power amplifier and the detector 14, and the control means 16 increases the gain of the amplifier, until the measured power value is equal to the stored value.

In each of the cases illustrated in Figures 1a and 1b, it may be noted that the detector 14 always detects the lower power value. Thus, the output power is controllable over a range substantially greater than the range of effective accurate measurement of the detector 14.

It will be appreciated that there does not need to be a linear relationship between the control voltage on amplifier control input 11 and the power measured by detector 14.

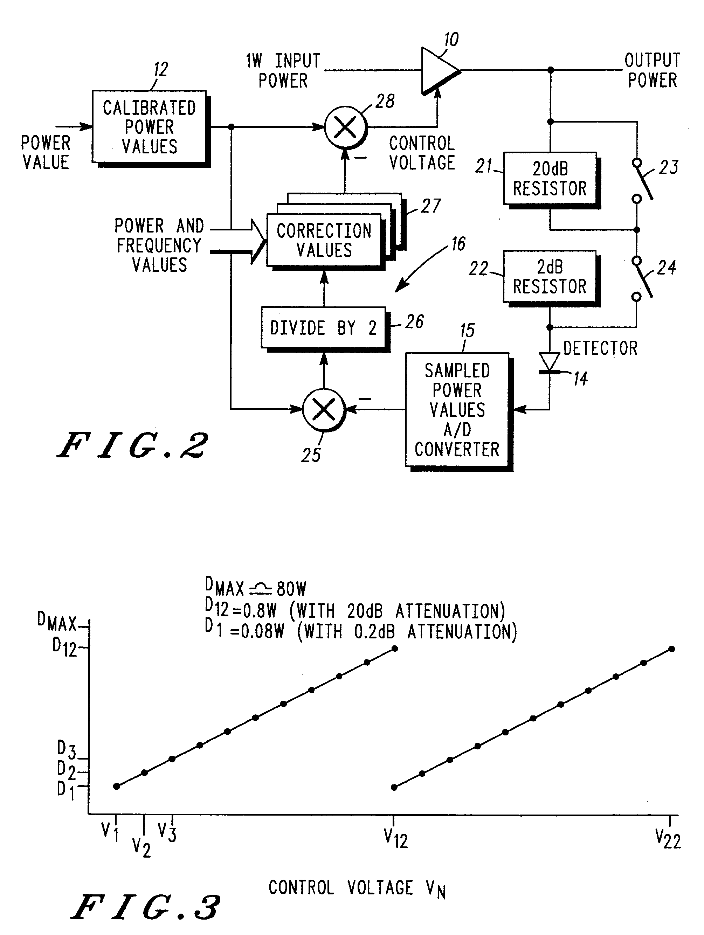

Referring to Figure 2, more detailed apparatus is shown for implementing the method of Figure 1a. In this figure, the attenuator means is shown to comprise a 20dB laser trimmed resistor pad 21 and a 2dB pad 22, each having a bypass switch, 23 and 24 respectively. The switches enable both pads to be connected in series, to provide their combined attenuation. The storage means 15 is an analog-to-digital converter providing digital power values to the memory of a microprocessor (not shown). The control means 16 is shown as comprising a comparator 25, a divider 26, frequency correction means 27 and a subtracter 28. These components can all be implemented in software and the resultant output of subtracter 28 can be converted to analogue form for controlling the power amplifier 10.

In general terms, the setting means 12 provides a series of calibrated power values, the derivation of which is described below. The circuit elements 25 to 28 facilitate power control during use, to equalise the output power to the desired power level. It will be appreciated that, because the output power level changes from one time slot to the next, the control loop provided does not control the output power instantaneously, but utilises previously measured power levels to control forthcoming time slots.

### Calibration

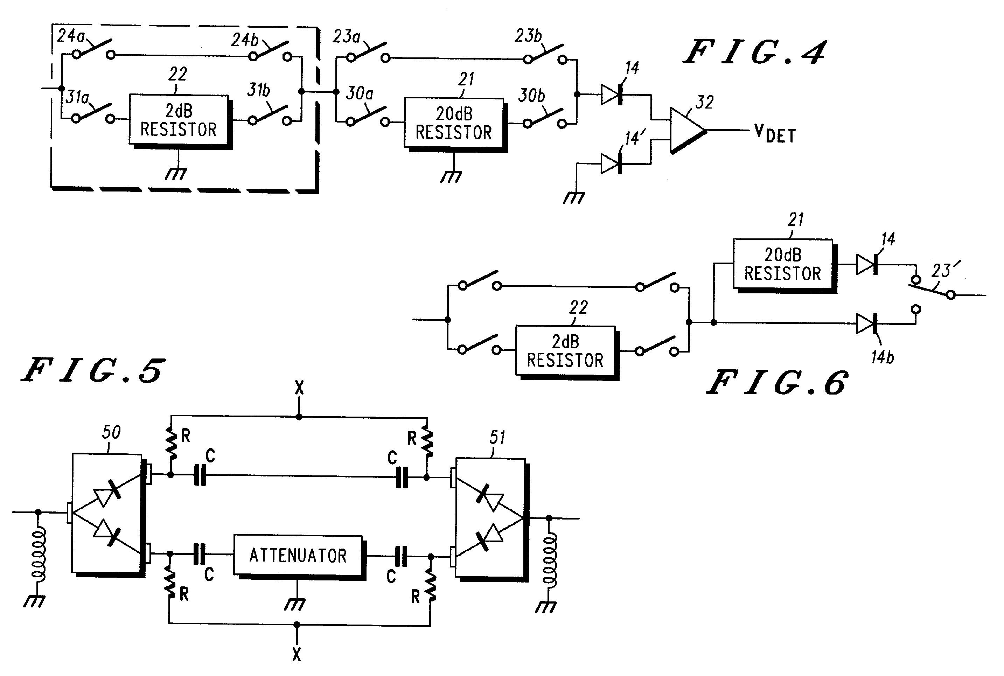

The maximum output power value is set manually, by adjusting the control voltage to the power amplifier 10, until the output power is measured to be the desired maximum level (e.g. 80 watts) using highly accurate calibration equipment. The voltage V₂₂ applied to the control input of the amplifier to provide this measured power is recorded in setting means 12. Thereafter, calibration is fully automatic and is carried out by a calibration routine stored in the microprocessor of the transmitter. This routine is now explained with reference to Figure 3.

The following steps are carried out.
(a) The 20dB pad 21 is switched into the detector circuit by opening switch 23 (with switch 24 closed.)
(b) The power amplifier is set to maximum power (80 watts), by recalling the calibrated power value V₂₂ from setting means 12.
(c) The resulting power value D₁₂ at the detector 14 is measured and stored in storage means 15.
(d) The control voltage V_{N} is decreased to zero and the 20dB pad is switched out of the circuit by closing switch 23.
(e) The control voltage to the power amplifier is increased from zero until the value D₁₂ stored in step (c) is detected at the detector 14.
(f) The control voltage V₁₂ required for step (e) is stored (the mid power value).
(g) The 20dB pad 21 is switched into the circuit again.
(h) Using the mid power control voltage V₁₂, the value D₂ measured by the detector 14 is stored. This is near the low point of the detector.

So far, only three control voltages have been stored, these being numbers V₂₂, V₁₂ and V₂ on Figure 3. In addition, two detector values have been stored D₁₂ and D₂.

The next stage in the procedure is to find control voltages for intermediate power levels between the maximum power and the mid power values V₂ and V₁₂, at 2dB intervals.
(i) With 20dB pad 21 switched out of the detector circuit, the 2dB pad 22 is switched in by opening switch 24.
(j) The control voltage is increased from zero to give the last detector value (the low point).
(k) The control voltage V₃ is stored.
(l) The 2dB pad is switched out by closing switch 24.
(m) The detector value D₃ is measured and stored.

Steps (i) to (m) are repeated, in each case using the last measured detector value and increasing the voltage with attenuation on the output until that detector value is achieved. In this manner, the various values V₃-V₁₁ and D₃-D₁₁ on Figure 3 are measured and stored.
(n) Having read ten sequential pairs of detector values and control voltages, it is possible to check the difference between the last pair of values and the values D₁₂ and V₁₂ read in steps (c) and (e). If there is a difference, the values read in steps (i) to (m) are interpolated to fit the previously measured range, i.e. to equalise the final measured values and the initially measured values. Interpolation has the effect of increasing or decreasing the incremental step between power control voltage values and/or the step between detector values. Having finally interpolated the values, they can be stored in read-only memory in setting means 12 and are thereafter available for use during transmitter operation.

Having read the detector values and control values for the steps 2 to 12 of the 42dB dynamic range, the next stage is to use the same detector values for the upper 2dB steps to read the control voltages. This is done as follows:
(o) Select the control voltage V₁₂ read in step (h);
(p) With the 20dB pad 21 switched into the detector circuit, the 2dB pad is switched out.
(q) The control voltage is increased from zero until each of the detector values D₂ to D₁₂ is reached in turn. At each value, the control voltage is stored. This gives the values V₁₃-V₂₁ and also a repeat value for V₂₂.
(r) Values V₁₃-V₂₁ are adjusted by linear interpolation so as to equalize the repeat value for V₂₂ with the originally set value (as for step n).

So far, twenty-one power control values and eleven detector values have been stored. The single remaining necessary pair of values is obtained by selecting V₂, measuring the detector value D₁ with both pads 21 and 22 switched in to the circuit, bypassing pad 22 and dropping the control voltage to the level V₁ at which detector value D₁ is measured. (Of course, if pad 21 had a greater value, e.g. 22dB, this step would be unnecessary, but an extra step in the sequence (a)-(r) would be required).

Upon completion of the calibration routine, a full table of twenty-one 8-bit control voltage values is stored in setting means 12.

It will be noted from Figure 3 that the upper half of the detector's range, from D₁₂ to D_{MAX}, is never used. Hence a detector can be used that has much less dynamic range. Also, the control voltage is always reduced to zero before bypassing either attenuator, so as not to exceed the detector's maximum power rating.

### Control During Operation

In order to correct for temperature, drift and frequency variations within the amplifier, a correction table is updated for each timeslot.

During operation, a required power level is selected by calling up the appropriate calibrated power value from setting means 12. With each time slot of transmission output, the output power is detected by detector 14 and sampled by the A/D converter in sample and storage means 15. If the output power is within the upper half of the range (as determined by the power level being selected), pad 21 is switched into the circuit, otherwise pad 21 is bypassed by switch 23. The detector value is translated into a control voltage error (by linear interpolation) and is divided by two in divider 26. The resultant value is stored in correction table 27, for use when the same power level and frequency combination is next selected.

Correction table 27 has space for 12 x 21 values - i.e. twenty-one power levels at twelve different frequencies. There are, in fact 124 different frequency channels that can be selected, but it is considered necessary to store values for every tenth channel only. Each entry stores a power correction value to a resolution of 0.1dB. One bit of each entry represents the sign of the correction (i.e. indicating whether the previously measured power was over power or under power). Upon power-up, the table 27 will be empty and it will gradually fill up with correction values as the transmitter is operated at different power levels at different frequencies.

The divider 26 provides a damping factor, allowing the actual output power to approach the calibrated output power over a series of time slots at the particular power level, without "hunting".

The frequency correction value allows compensation for the fact that a given control voltage will not necessarily give rise to the same output power over the whole frequency range of the amplifier.

It will, of course, be understood that the frequency correction values 27 could be implemented by other means. For example, the values stored could be detector values, and the conversion to power values and division by 2 could be carried out upon read-out. A similar table may be provided for temperature correction, allowing correction values to be selected in response to temperature measured by a thermostat.

The invention has the advantage that re-calibration of the power amplifier is very simple in the field. If, for example, it is necessary to replace the power amplifier of a transmitter (as is often the case in the event of lightning strike), all that is necessary for re-calibration is that the field engineer calibrates the replacement amplifier to the high power value. Thereafter, the microprocessor can enter a calibration routine which allows every other value for the control voltage at the calibration points to be determined automatically. In addition, means may be provided for receipt of a recalibration instruction, e.g. over the r.f. interface, or from a monitoring receiver, causing automatic initiation of the calibration program of steps (a) to (r).

Instead of the above described interpolation routine, an alternative method of ensuring that the start point for the calibration coincides with the finishing point is to repeat the calibration and at each stage replace the method of Figure 1a with that of Figure 1b (or vice versa) I.e., instead of using the 20dB pad to step the power down and then using the 2dB pad to step up in 10 incremental steps to return to the original point, the opposite can be done, stepping the power down in 2dB steps and, after 10 such steps, stepping up again in one 20dB step. When 10 calibration points have been derived by each method, the average point is taken between corresponding pairs from the two sets of points so derived.

Referring to Figure 4, further, preferred details of the attenuators 21 and 22, the switches 23 and 24 and the detector 14 of figure 2 are shown. It can be seen that switch 23 comprises two parts - 23a and 23b and switch 24 likewise comprises two parts - 24a and 24b. On either side of attenuator 21, there is a further switch 30a and 30b, and likewise there is a further switch, 31a and 31b, on either side of the attenuator 22. In addition to detector 14, there is a further detector 14' and the detectors 14 and 14' are applied to the + and - inputs of a comparator 32.

The purpose of the additional switches 30a, 30b, 31a and 31b is to isolate the attenuators 21 and 22 when they are short-circuited. This is necessary, because each attenuator comprises a T-network of resistors, with the stem of the T being connected to ground. For this reason, unless the attenuator is isolated, it still has a residual effect even when it is short circuited. Because the switches are not lossless switches, it is necessary to provide two switches in the short-circuit path (23a and 23b etc) in order to balance the corresponding switches 30a and 30b on either side of the attenuator 21.

The purpose of the additional detector 14' is for temperature compensation. The two detectors 14 and 14' are mounted in the same housing, in isothermal relationship, as is described in EP-A-0369135.

Referring to Figure 5, further details are shown of the switches and attenuator within the dotted line on Figure 4. From this figure, it can be seen that the switches 24a and 31a are implemented in the surface-mount diode pair 50 and the switches 24b and 31b are implemented in a further diode pair 51. Various other resistors, capacitors and inductances are shown, which need not be described in detail, but which cause the diode pairs to act as switches in a manner known in the general art. It is a novel feature of the preferred embodiment of the invention that surface mount diode pair 51 is a mirror image of surface mount diode pair 50. This allows for a very compact arrangement of the components on a circuit board.

The provision of a first surface mount device comprising a first pair of diodes having a common electrode and a second surface mount device which is a mirror image of the first surface mount device has wider uses that just for the switching of attenuators.

Referring to Figure 6, an alternative arrangement for the 20dB pad 21 , the switch 23 and the detector 14 is shown. In this alternative arrangement, a second detector 14b is provided in permanent serial connection with the 20dB pad 21. Instead of an open/closed switch 23, a two-way switch 23' is provided for selecting either the detector 14 or the detector and attenuator 14b and 21 for output power measurement. A power value measured by one detector is subsequently used to control the amplifier power under output power measurement by the other detector. Care must be taken to ensure that the two detectors have the same characteristic. The arrangement has the advantage of switching d.c. instead of a.c.

It will, of course, be understood that the above description has been given by way of example only, and that modifications can be made within the scope of the invention.

## Claims

1. An amplifier comprising a controllable output power stage (10), power setting means (12) for setting the output power, and a control loop for adjusting the output power, the control loop comprising measuring means (14) for measuring the output power and comparison means (28) for comparing the power measured with the power set and adjusting the output power in response thereto, the amplifier further comprising attenuator means (21, 22) switchable into the control loop for causing the measuring means to measure attenuated power, storage means (15) for storing a value for measured power and means for using a stored value derived from a first switched state of attenuation for adjustment of the output power during a second switched state of attenuation, thereby to allow a wide adjustment of output power over a narrow range of measured power.

2. An amplifier according to claim 1, wherein the attenuator means comprises a large attenuator (21) and a small attenuator (22) and switching means (23, 24) for switching one or both of said attenuators into the control loop.

3. A method of controlling the output power of an amplifier, comprising the steps of:
a) setting an output power stage (10) to provide a desired higher output power, attenuating the output power in an attenuator (21, 22), and measuring and storing a value for the attenuated output power
b) deactivating the attenuator and
c) adjusting the setting of the output power stage until substantially the same output power value is measured as the stored value, thereby providing a decreased output power, the value of which is controllable to substantially the same degree of accuracy as the measurement of the previously attenuated higher output power.

4. A method of controlling the output power of an amplifier, comprising the steps of:
a) setting an output power stage (10) to provide a desired lower output power, and measuring and storing a value for said output power,
b) attenuating the output power in an attenuator (21, 22),
c) adjusting the setting of the output power stage until substantially the same output power value is measured as the stored value, thereby providing an increased output power, the value of which is controllable to substantially the same degree of accuracy as the measurement of the previously set lower output power.

5. A method according to claim 3 or 4, further comprising the steps of attenuating the output power in large (21) and small (22) increments, and storing power values and corresponding output power stage settings which provide different output powers across a complete power range greater than one of said large increments, said different output powers being separated by amounts substantially equal to said small increments.

6. A method according to claim 5, wherein, by said method, the output power is set to different levels extending over a range by a series of steps including at least one large incremental step in one direction and a series of small incremental steps in the other direction so as to adjust the power back to the original level and, when the power has been adjusted over the whole range, a comparison is made between the original measured level and the final measured level and, by interpolation, the stored settings for the intermediate small incremental steps are adjusted so as to equalise the final level to the originally measured level.

7. A method of controlling the output power of an amplifier comprising the steps of obtaining a set of power settings separated by incremental steps by the method of claim 3 and a set of similar power settings separated by incremental steps by the method of claim 4 and averaging corresponding values in the two sets.

8. A method according to any one of claim 5 to 7, wherein the method is executed automatically by the amplifier upon provision of an initial output power stage setting.

9. A method according to any one of claims 3 to 8, comprising the further steps of storing values (27) representative of the measured and stored output values for different output power levels and frequencies and using those stored values for correction of the output power when those power levels and frequencies are next selected for output.

## Patentansprüche

1. Verstärker umfassend eine regelbare Ausgangsleistungsstufe (10), eine Leistungseinstelleinrichtung (12), um die Ausgangsleistung einzustellen, und eine Regelschleife zum Einregeln der Ausgangsleistung, wobei die Regelschleife eine Meßeinrichtung (14) zum Messen der Ausgangsleistung und eine Vergleichseinrichtung (28) zum Vergleichen der gemessenen Leistung mit der eingestellten Leistung und Einregeln der Ausgangsleistung als Reaktion darauf umfaßt, wobei der Verstärker weiter eine in die Regelschleife schaltbare Dämpfungseinrichtung (21, 22), um die Meßeinrichtung zu veranlassen, eine abgeschwächte Leistung zu messen, eine Speichereinrichtung (15), um einen Wert für gemessene Leistung zu speichern, und eine Einrichtung umfaßt, um einen von einem ersten geschalteten Dämpfungszustand gewonnenen gespeicherten Wert zum Einregeln der Ausgangsleistung während eines zweiten geschalteten Dämpfungszustands zu verwenden, um dadurch eine weite Einregelung der Ausgangsleistung über einem schmalen Bereich gemessener Leistung zu erlauben.

2. Verstärker nach Anspruch 1, worin die Dämpfungseinrichtung einen großen Abschwächer (21) und einen kleinen Abschwächer (22) und eine Schalteinrichtung (23, 24) umfaßt, um einen oder beide Abschwächer in die Regelschleife hineinzuschalten.

3. Verfahren zur Regelung der Ausgangsleistung eines Verstärkers, umfassend die Schritte:
(a) Einstellen einer Ausgangsleistungsstufe (10), um eine gewünschte höhere Ausgangsleistung zu liefern, Abschwächen der Ausgangsleistung in einem Abschwächer (21, 22) und Messen und Speichern eines Werts für die abgeschwächte Ausgangsleistung
(b) Deaktivieren des Abschwächers und
(c) Einregeln der Einstellung der Ausgangsleistungsstufe bis im wesentlichen der gleiche Ausgangsleistungswert wie der gespeicherte Wert gemessen wird, um dadaurch eine verminderte Ausgangsleistung bereitzustellen, deren Wert auf im wesentlichen den gleichen Genauigkeitsgrad regelbar ist wie die Messung der zuvor abgeschwächten höheren Ausgangsleistung.

4. Verfahren zur Regelung der Ausgangsleistung eines Verstarkers, umfassend die Schritte:
(a) Einstellen einer Ausgangsleistungsstufe (10), um eine gewünschte niedrigere Ausgangsleistung zu liefern, und Messen und Speichern eines Werts für diese Ausgangsleistung,
(b) Abschwächen der Ausgangsleistung in einem Abschwächer (21, 22),
(c) Einregeln der Einstellung der Ausgangsleistungsstufe bis im wesentlichen der gleiche Ausgangsleistungswert wie der gespeicherte Wert gemessen wird, um dadaurch eine erhöhte Ausgangsleistung bereitzustellen, deren Wert auf im wesentlichen den gleichen Genauigkeitsgrad regelbar ist wie die Messung der zuvor eingestellten niedrigeren Ausgangsleistung.

5. Verfahren nach Anspruch 3 oder 4, weiter umfassend die Schritte des Abschwächens der Ausgangsleistung in großen (21) und kleinen (22) Inkrementen, und des Speicherns der Leistungswerte und der entsprechenden Ausgangsleistungsstufen-Einstellungen, die verschiedene Ausgangsleistungen über einem gesamten Leistungsbereich liefern, der größer ist als eines der großen Inkremente, wobei die verschiedenen Ausgangsleistungen durch Beträge getrennt sind, die im wesentlichen gleich den kleinen Inkrementen sind.

6. Verfahren nach Anspruch 5, worin durch dieses Verfahren die Ausgangsleistung auf verschiedene, sich über einen Bereich erstrekkende Pegel durch eine Reihe von Schritten mit mindestens einem großen Teilschritt in einer Richtung und einer Reihe von kleinen Teilschritten in der anderen Richtung eingestellt wird, so daß die Leistung zurück zu dem ursprünglichen Pegel justiert wird, und wenn die Leistung über dem ganzen Bereich justiert worden ist, wird ein Vergleich zwischen dem ursprünglich gemessenen Pegel und dem letzten gemessenen Pegel gemacht, und durch Interpolation werden die gespeicherten Einstellungen für die kleinen Zwischenteilschritte justiert, um den letzten Pegel dem ursprünglich gemessenen Pegel anzugleichen.

7. Verfahren zur Regelung der Ausgangsleistung eines Verstärkers, umfassend die Schritte des Erlangens eines Satzes von Leistungseinstellungen, die durch Teilschritte durch das Verfahren von Anspruch 3 getrennt sind, und eines Satzes ähnlicher Leistungseinstellungen, die durch Teilschritte durch das Verfahren von Anspruch 4 getrennt sind, und der Mittelwertbildung entsprechender Werte in den zwei Sätzen.

8. Verfahren nach einem der Ansprüche 5 bis 7, worin das Verfahren durch den Verstärker nach Bereitstellung einer anfänglichen Ausgangsleistungsstufen-Einstellung automatisch ausgeführt wird.

9. Verfahren nach einem der Ansprüche 3 bis 8, umfassend die weiteren Schritte des Speicherns von Werten (27), die gemessene und gespeicherte Ausgangswerte für verschiedene Ausgangsleistungspegel und Frequenzen darstellen, und der Verwendung dieser gespeicherten Werte zur Korrektur der Ausgangsleistung, wenn diese Leistungspegel und Frequenzen nächstens zur Ausgabe gewählt werden.

## Revendications

1. Amplificateur comprenant un étage de puissance de sortie commandable (10), un moyen d'établissement de puissance (12) pour établir la puissance de sortie et une boucle de commande pour régler la puissance de sortie, la boucle de commande comprenant un moyen de mesure (14) pour mesurer la puissance de sortie et un moyen de comparaison (28) pour comparer la puissance mesurée à la puissance établie et pour régler la puissance de sortie en réponse à la comparaison, l'amplificateur comprenant en outre un moyen d'atténuateur (21, 22) commutable dans la boucle de commande pour amener le moyen de mesure à mesurer une puissance atténuée, un moyen de stockage (15) pour stocker une valeur de puissance mesurée et un moyen pour utiliser une valeur stockée dérivée d'un premier état commuté d'atténuation pour le réglage de la puissance de sortie pendant un second état commuté d'atténuation, pour ainsi permettre un réglage large de la puissance de sortie sur une plage étroite de puissance mesurée.

2. Amplificateur selon la revendication 1, dans lequel le moyen d'atténuateur comprend un grand atténuateur (21) et un petit atténuateur (22) ainsi qu'un moyen de commutation (23, 24) pour commuter l'un desdits atténuateurs ou les deux dans la boucle de commande.

3. Procédé de commande de la puissance de sortie d'un amplificateur, comprenant les étapes de :
a) établissement d'un étage de puissance de sortie (10) pour produire une puissance de sortie plus élevée souhaitée, atténuation de la puissance de sortie dans un atténuateur (21, 22) et mesure ainsi que stockage d'une valeur pour la puissance de sortie atténuée ;
b) désactivation de l'atténuateur ;
c) réglage de l'établissement de l'étage de puissance de sortie jusqu'à ce que sensiblement la même valeur de puissance de sortie soit mesurée en tant que valeur stockée, d'où la fourniture d'une puissance de sortie diminuée dont la valeur peut être commandée selon sensiblement le même degré de précision que la mesure de la puissance de sortie plus élevée atténuée précédemment.

4. Procédé de commande de la puissance de sortie d'un amplificateur, comprenant les étapes de :
a) établissement d'un étage de puissance de sortie (10) pour produire une puissance de sortie inférieure souhaitée et mesure et stockage d'une valeur pour ladite puissance de sortie ;
d) atténuation de la puissance de sortie dans un atténuateur (21, 22) ;
c) réglage de l'établissement de l'étage de puissance de sortie jusqu'à ce que sensiblement la même valeur de puissance de sortie soit mesurée en tant que valeur stockée pour ainsi produire une puissance de sortie augmentée dont la valeur peut être commandée jusqu'à sensiblement le même degré de précision que la mesure de la puissance de sortie inférieure établie précédemment.

5. Procédé selon la revendication 3 ou 4, comprenant en outre les étapes d'atténuation de la puissance de sortie selon des incréments grands (21) et petits (22) et de stockage de valeurs de puissance et d'établissement d'étages de puissance de sortie correspondants qui produisent des puissances de sortie différentes sur une plage de puissance complète supérieure à l'un desdits incréments grands, lesdites puissances de sortie différentes étant séparées par des valeurs sensiblement égales auxdits petits incréments.

6. Procédé selon la revendication 5, dans lequel, au moyen dudit procédé, la puissance de sortie est établie à des niveaux différents s'étendant sur une plage au moyen d'une série de pas incluant au moins un grand pas incrémentiel suivant une direction et une série de petits pas incrémentiels suivant l'autre direction de manière à régler la puissance en retour au niveau original et lorsque la puissance a été réglée sur la totalité de la plage, une comparaison est effectuée entre le niveau mesuré original et le niveau mesuré final et par interpolation, les établissements stockés pour les petits pas incrémentiels intermédiaires sont réglés de manière à rendre le niveau final égal au niveau mesuré originellement.

7. Procédé de commande de la puissance de sortie d'un amplificateur comprenant les étapes d'obtention d'un jeu d'établissements de puissance séparés par des pas incrémentiels au moyen du procédé selon la revendication 3 et d'un jeu d'établissements de puissance similaires séparés par des pas incrémentiels au moyen du procédé selon la revendication 4 et de calcul de la moyenne des valeurs correspondantes dans les deux jeux.

8. Procédé selon l'une quelconque des revendications 5 à 7, dans lequel le procédé est exécuté automatiquement par l'amplificateur suite à la fourniture d'un établissement d'étage de puissance de sortie initial.

9. Procédé selon l'une quelconque des revendications 3 à 8, comprenant les étapes supplémentaires de stockage de valeurs (27) représentatives des valeurs de sortie mesurées et stockées pour différents niveaux de puissance de sortie et pour différentes fréquences de puissance de sortie et d'utilisation de ces valeurs stockées pour une correction de la puissance de sortie lorsque ces niveaux de puissance et ces fréquences de puissance sont ensuite sélectionnés en vue d'une sortie.
